Europäisches Patentamt

European Patent Office

Office européen des brevets

(19)

(11) EP 0 516 233 B1

# (12) FASCICULE DE BREVET EUROPEEN

(45) Date de publication et mention
de la délivrance du brevet:
**21.02.1996 Bulletin 1996/08**

(51) Int Cl.$^6$: **G09G 5/34**

(21) Numéro de dépôt: **92201471.7**

(22) Date de dépôt: **22.05.1992**

(54) **Dispositif pour visualiser des vues partielles d'une image**

Vorrichtung zum Darstellen von Teilansichten eines Bildes

Device for displaying partial views of a picture

(84) Etats contractants désignés:
**DE FR GB**

(30) Priorité: **31.05.1991 FR 9106587**

(43) Date de publication de la demande:
**02.12.1992 Bulletin 1992/49**

(73) Titulaires:
- **PHILIPS ELECTRONIQUE GRAND PUBLIC**
  **F-92150 Suresnes (FR)**
  Etats contractants désignés:
  **FR**
- **Philips Electronics N.V.**
  **NL-5621 BA Eindhoven (NL)**
  Etats contractants désignés:
  **DE GB**

(72) Inventeurs:
- **Gibert, Bertrand**
  **F-75008 Paris (FR)**
- **Oberkampf, Frédéric**
  **F-75008 Paris (FR)**

(74) Mandataire: **Chaffraix, Jean et al**
  **F-75008 Paris (FR)**

(56) Documents cités:
  **EP-A- 0 104 431**        **EP-A- 0 235 594**
  **EP-A- 0 403 416**        **GB-A- 2 070 399**
  **GB-A- 2 115 660**        **US-A- 4 920 504**

## Description

La présente invention concerne un dispositif pour visualiser sur un écran des vues partielles d'une image, dispositif comportant :

- une mémoire de masse pour emmagasiner tous les pixels de l'image préalablement numérisée,
- un organe de visualisation muni d'un écran pour visualiser les vues partielles,
- une mémoire tampon pour recevoir des informations de la mémoire de masse et pour alimenter l'organe de visualisation,
- un circuit d'utilisateur pour sélectionner des vues partielles se déduisant les unes des autres par scrolling en agissant sur une commande de déplacement.

Ces dispositifs trouvent d'importantes applications lorsqu'il s'agit de visualiser, par exemple sur un écran cathodique du type usuel, des cartes géographiques. Comme celles-ci comportent en général un bon nombre de détails, l'organe de visualisation ne permet d'en restituer qu'une partie. Au moyen du circuit d'utilisateur, on sélectionne successivement des vues partielles de telle sorte que l'on obtient l'impression de se déplacer dans la carte. Pour le confort de l'utilisateur, ce déplacement doit se produire avec douceur et sans à-coups.

Le brevet des Etats-Unis d'Amérique n° 4 602 251 décrit un tel dispositif. Ce dispositif connu comporte une mémoire tampon dont la capacité est prévue pour contenir d'une part les informations concernant la vue partielle à visualiser et d'autre part des informations de rafraîchissement provenant de la mémoire de masse et destinées à la mise à jour de la vue présentée à l'écran lorsqu'un déplacement dans l'image est désiré par l'utilisateur.

Ce dispositif connu présente l'inconvénient que la mémoire tampon est plus grande que nécessaire et implique l'utilisation d'une mémoire de masse à accès rapide.

La présente invention concerne un dispositif du genre mentionné dans le préambule, qui permet l'utilisation d'une mémoire tampon de capacité réduite et ne nécessite pas une mémoire de masse à accès rapide.

Pour cela, un tel dispositif est remarquable en ce que la mémoire tampon est divisée en au moins :

- une première partie dite partie globale comprenant :

  . une sous-partie de transfert contenant
  . une sous-partie de lecture contenant
  . une sous-partie d'écran correspondant à la partie visualisée, la sous-partie d'écran se déplaçant en fonction du mouvement de la commande de déplacement,

- une deuxième partie dite partie supplémentaire destinée à recevoir les informations de la mémoire de masse lorsque la sous-partie d'écran entre en contact avec la sous-partie de lecture, et à fournir à la partie globale ces informations lorsque la sous-partie d'écran entre en contact avec la sous-partie de transfert.

La présente invention est particulièrement adaptée pour être appliquée au système Compact Disque Interactif tel que décrit dans l'ouvrage :

"Compact Disc Interactive A Designer's Overview" rédigé par J.M.Preston - PHILIPS International édité par KLUWER TECHNICAL BOOKS DEVENTER - Anvers Belgique

En effet les disques compacts contiennent beaucoup d'informations et de ce fait l'accès à une information donnée est relativement lent et l'invention remédie dans une large mesure à cet accès lent.

La description suivante accompagnée des dessins ci-annexés, le tout donné à titre d'exemple non limitatif, fera bien comprendre comment l'invention peut être réalisée.

La figure 1 représente un schéma du dispositif de l'invention.

La figure 2 montre une image (une carte géographique) à visualiser.

La figure 3 montre comment les blocs de pixels de l'image sont organisés.

La figure 4 montre comment un bloc de pixels est décomposé.

La figure 5 montre la manière selon laquelle les différents pixels sont enregistrés dans la mémoire de masse.

La figure 6 montre comment la mémoire tampon peut être chargée à partir de la mémoire de masse.

La figure 7 montre les différents rectangles : rectangle global, de lecture, de transfert.

La figure 8 est un schéma explicitant l'adressage de la mémoire tampon pour la visualisation.

Les figures 9 et 10 montrent le transfert des blocs depuis la mémoire de masse jusqu'à la mémoire tampon.

La figure 11 montre le changement de ligne à prévoir lors du transfert d'une valeur de bloc.

Les figures 12, 13 et 14 sont des organigrammes explicitant le fonctionnement du dispositif.

La figure 15 montre la signification de différents paramètres.

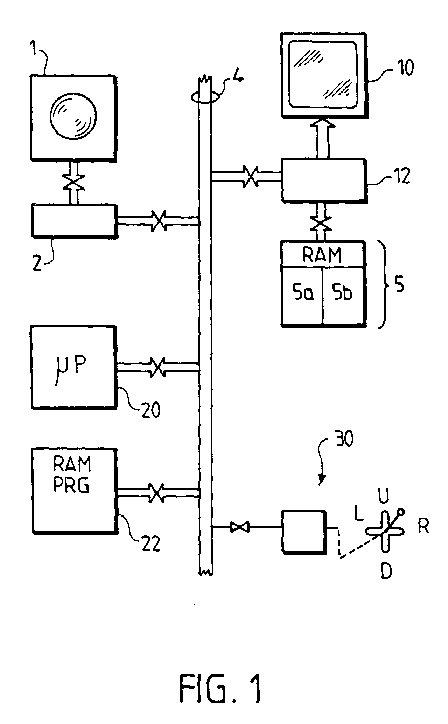

Le dispositif de la figure 1 comporte tout d'abord une mémoire de masse 1 contenant toutes les informations relatives aux pixels d'une carte géographique. Cette mémoire est constituée par un disque optique monté dans son lecteur qui est commandé par un organe de contrôle 2. Les informations prélevées dans cette mémoire peuvent être transmises via une ligne commune (BUS) 4 dans une mémoire tampon 5 qui est divisée en au moins deux parties :

- une première partie 5a dite partie globale dont une sous-partie est lue pour faire apparaître l'image sur l'organe de visualisation 10 via un contrôleur de visualisation 12,
- une deuxième partie 5b dite partie supplémentaire.

A la ligne commune 4 sont aussi rattachés un microprocesseur 20 qui commande toutes les opérations, une mémoire de programme 22 qui contient le programme à exécuter, lequel peut être chargé au démarrage du dispositif à partir de la mémoire de masse 1.

Il est prévu aussi un circuit utilisateur 30 pour sélectionner une vue partielle, montrée à l'écran 10, de toute l'image emmagasinée dans la mémoire de masse 1. Quatre déplacements peuvent être choisis :

U : déplacement vers le haut
D : déplacement vers le bas
L : déplacement vers la gauche
R : déplacement vers la droite

La structure du dispositif montré à la figure 1 est celle d'un produit connu sous le nom de CDI (voir l'ouvrage cité ci-dessus).

Afin de bien expliquer l'invention, on va décrire un cas bien particulier avec des valeurs numériques, ceci pour des raisons de clarté. Mais il est entendu que l'invention n'est pas limitée à cet exemple.

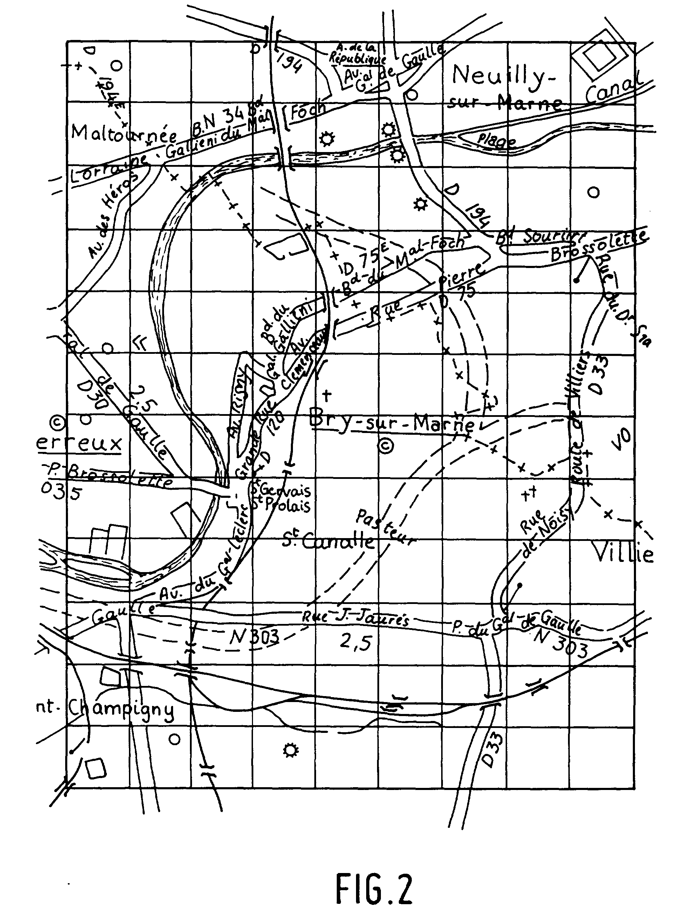

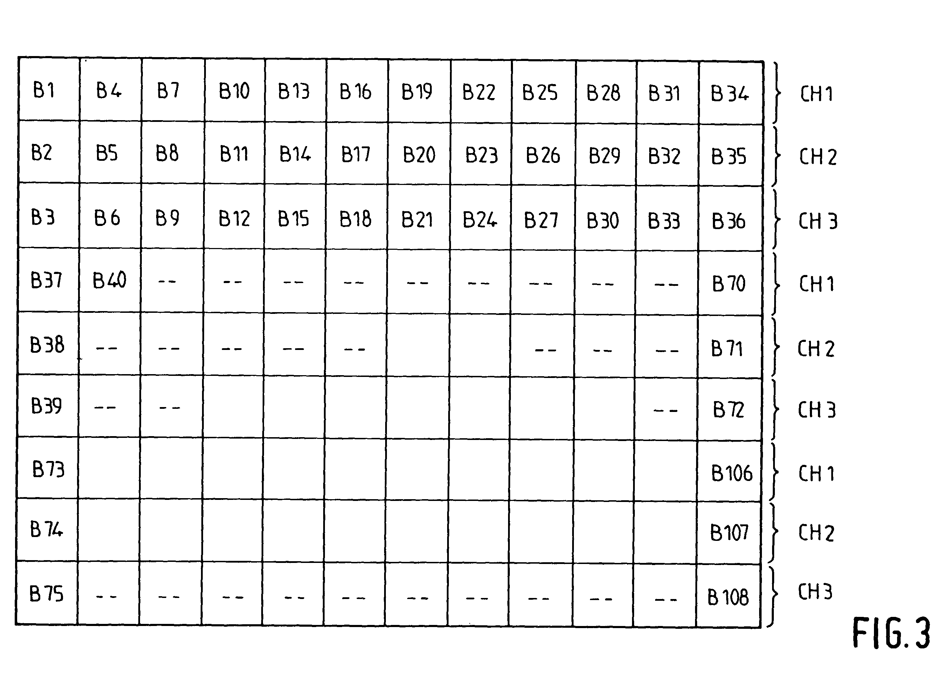

Tout d'abord, on va décrire la manière dont est emmagasinée l'image ; dans cet exemple, c'est une carte géographique montrée à la figure 2. Cette carte est découpée en 108 blocs dont les références et les emplacements respectifs sont explicités à la figure 3. Ces blocs portent les références B1 à B108.

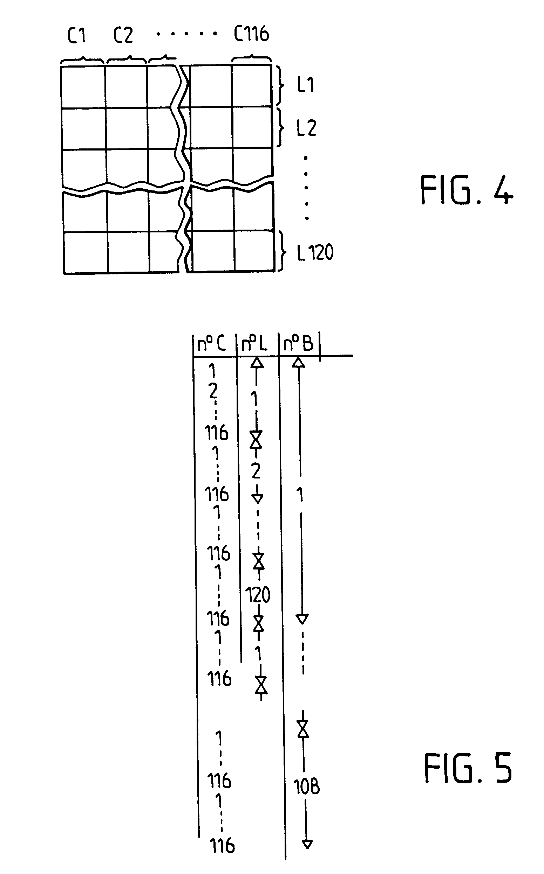

La figure 4 montre la constitution de chacun de ces blocs. Ces blocs sont formés de 116 colonnes de pixels C1 à C116 chaque colonne est formée de 120 pixels de telle sorte que le bloc est aussi formé de 120 lignes L1 à L120 de 116 pixels.

Pour enregistrer les images, on profite d'une des facilités du CDI procurées par ces canaux, ainsi les blocs B1, B4, ..., B34, B37, ..., B70, B73, ..., B106 sont enregistrés via le canal CH1, les blocs B2, B5, ..., B35, B38, ..., B71, B74, ..., B107 via le canal CH2, et les blocs B3, B6, ..., B36, B39, ..., B72, B75, ..., B108 via le canal CH3.

Ainsi, à la figure 3, les blocs B1 à B36 forment un premier groupe, les blocs B37 à B72 un deuxième groupe et les blocs B73 à B108 un troisième groupe. L'image est traitée groupe par groupe. Dans chaque groupe, les blocs sont traités colonne par colonne, chaque rangée étant associée à un canal :

- B1 au canal CH1, B2 au canal CH2, B3 au canal CH3,
- B4 au canal CH1, B5 au canal CH2, etc...

On rappelle que l'on peut utiliser jusqu'à 32 canaux mais qu'ici 3 seulement sont utilisés.

La figure 5 montre la séquence selon laquelle les informations sont enregistrées. Les blocs B1, B2, B3, ..., B108 sont enregistrés dans cet ordre, tout à tour, en commençant par les 116 pixels de la ligne L1 jusqu'à la ligne L120.

C'est à partir de ces informations qu'on va charger la mémoire tampon 5. Cette mémoire contient 20 blocs (5 x 4) contigus pris parmi les 108.

Il convient de remarquer que le chargement total de cette mémoire s'effectue en deux temps.

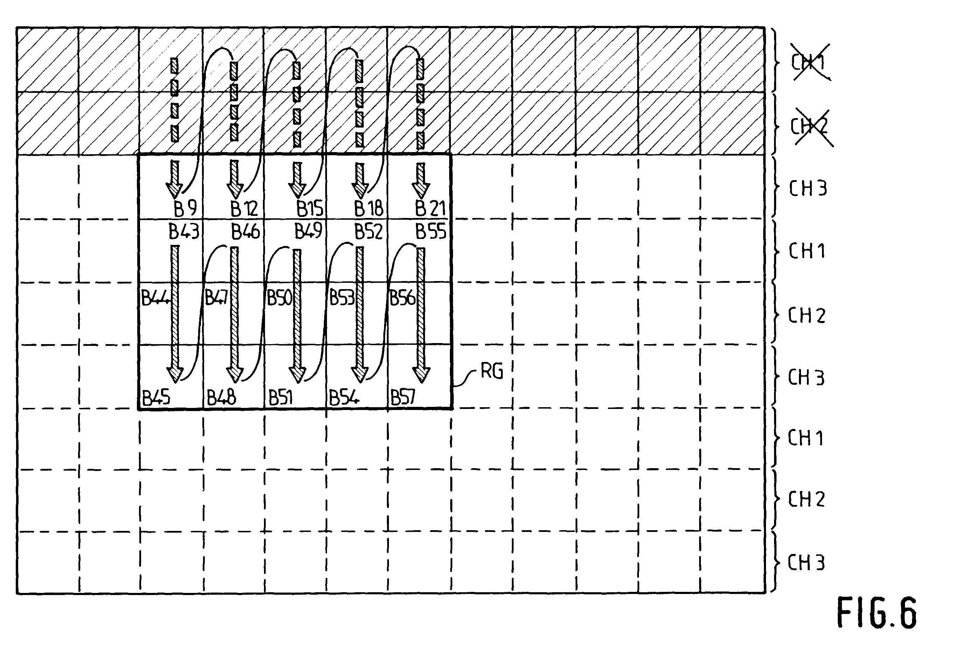

Par exemple si on veut charger la mémoire 10 des blocs B9, B12, B15, B18, B21 et B43 à B57, ceci s'effectue dans un premier temps en ouvrant le canal 3 pour lire dans la mémoire de masse les blocs B9, B12, B15, B18 et B21 et en fermant les canaux 1 et 2 et dans un deuxième temps en ouvrant les canaux CH1, CH2 et CH3 pour lire les blocs B43 à B57 ; ceci est explicité à la figure 6.

Vingt blocs sont donc enregistrés dans la mémoire tampon 5 dans la partie 5a. De tous les pixels de ces 20 blocs (20 x 116 x 120 = 278400) seuls 107520 (= 384 x 280) sont prélevés dans la mémoire tampon pour être affichés sur l'organe de visualisation 10.

Ces blocs sont arrangés dans la mémoire tampon de telle manière qu'en adressant continûment celle-ci on puisse faire apparaître l'image.

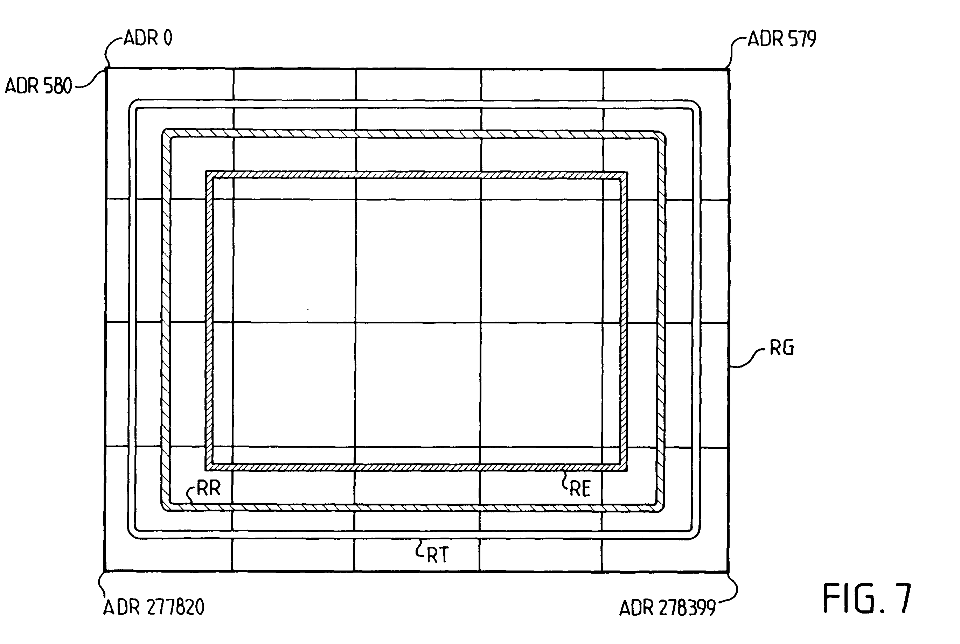

Ainsi, par exemple les adresses "0 à 115" contiennent les pixels de la ligne L1 du bloc B9, les adresses "116 à 231" les pixels de la ligne L1 du bloc B12, puis la ligne L1 des blocs B15, B18, B21, puis la ligne L2 de ces mêmes blocs B9, B12, B15, B18, B21 et ainsi de suite jusqu'à la ligne L120. Ensuite ce sera au tour de la ligne L1 des blocs. Ces différentes adresses sont représentées à la figure 7 avec un préfixe ADR.

Selon l'invention on définit dans la mémoire tampon 5 et plus précisément dans la partie 5a différentes sous-parties représentées à la figure 7 par des rectangles :

- le rectangle RG qui correspond à tout l'adressage de la partie 5a c'est-à-dire des codes d'adresse ADR0 à ADR278399,
- le rectangle RT qui correspond à la sous-partie de transfert qui commence à l'adresse ADR17400 et s'étend sur 520 pixels x 420 lignes,
- le rectangle RR qui correspond à la sous-partie de lecture qui commence à l'adresse ADR30210 et s'étend sur 480 pixels x 376 lignes,
- le rectangle RE qui correspond à la sous-partie d'écran, qui se déplace à l'intérieur des rectangles précités en fonction du déplacement "U", "D", "R" et "L" demandé et qui s'étend sur 384 pixels x 280 lignes.

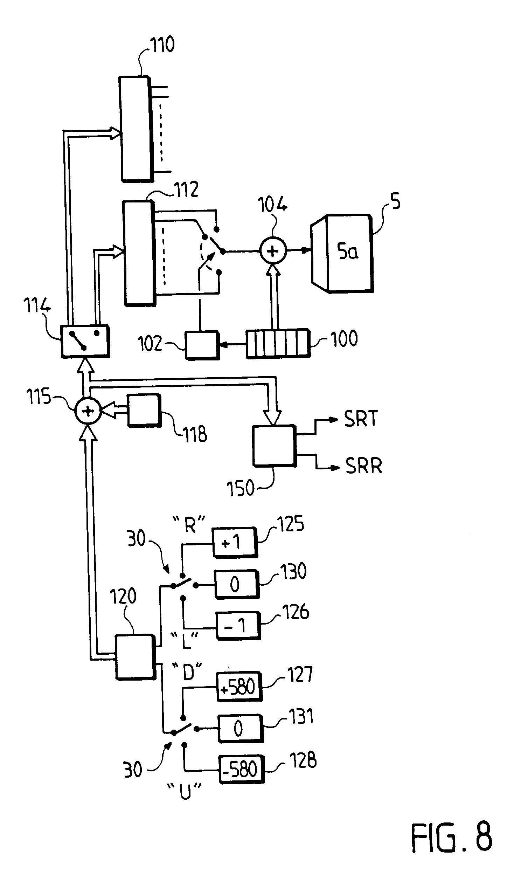

La figure 8 montre comment la mémoire tampon est adressée et plus particulièrement l'adressage des pixels situés dans le rectangle d'écran.

Il est prévu tout d'abord un compteur 100 dont la capacité est égale au nombre de pixels contenus dans une ligne, soit 580, chaque passage à zéro de compteur est comptabilisé dans un compteur de ligne 102.

Le contenu de compteur va être modifié par un additionneur 104 recevant sur d'autres entrées des informations donnant l'adresse de chaque ligne. Ces informations de ligne donnent pour chaque ligne l'adresse du premier pixel qui doit être lu dans la mémoire 5a. Ces informations sont contenues dans une double table 110 et 112. Une de ces tables est lue (sur la figure 8 c'est la table 112) tandis que l'autre est mise à jour, c'est la table 110 de préférence qui est lue lors du temps de retour trame. Chaque début de ligne contenu dans la mémoire 112 est sélectionné au moyen du compteur de ligne 102. Un commutateur 114 permet le chargement des tables 110 et 112 alternativement.

Ces adresses de début de ligne sont élaborées au moyen d'un additionneur 115 modulo 278400 donc correspondant au champ d'adressage du Rectangle Global RG additionnant d'une part les conditions initiales de début de ligne correspondant par exemple au centrage du rectangle RE dans le rectangle global et d'autre part les accumulations accumulant les demandes de déplacement horizontal ou vertical effectuées au moyen des commandes 30. Les conditions initiales sont obtenues par des moyens d'initialisation figurés sur la figure 8 par une boîte 118 et les accumulations sont obtenues par un accumulateur 120. L'accumulateur fournit le décalage à apporter à chaque ligne en fonction du déplacement demandé, + 1 pour un déplacement à droite, - 1 pour un déplacement à gauche, + 580 pour un déplacement vers le bas et - 580 pour un déplacement vers le haut. Ceci est représenté respectivement par des boîtes 125, 126, 127 et 128. Au repos, lorsqu'aucun déplacement n'est demandé, ce sont les boîtes 130 et 131 qui sont sollicitées, le contenu de l'accumulateur 120 restant invariable.

Un décodeur 150 rattaché à l'additionneur 115 fournit les signaux SRT et SRR signifiant le contact du rectangle RE avec les rectangles RT et RR respectivement.

Pour bien comprendre l'invention, on va seulement décrire un déplacement vers la droite. Il sera après facile de déterminer le fonctionnement pour un déplacement vers la gauche, vers le haut ou vers le bas.

On se place dans la disposition indiquée, c'est-à-dire celle où le rectangle global comporte les blocs B9, B12, B15, B18, B21, ..., B54, B57.

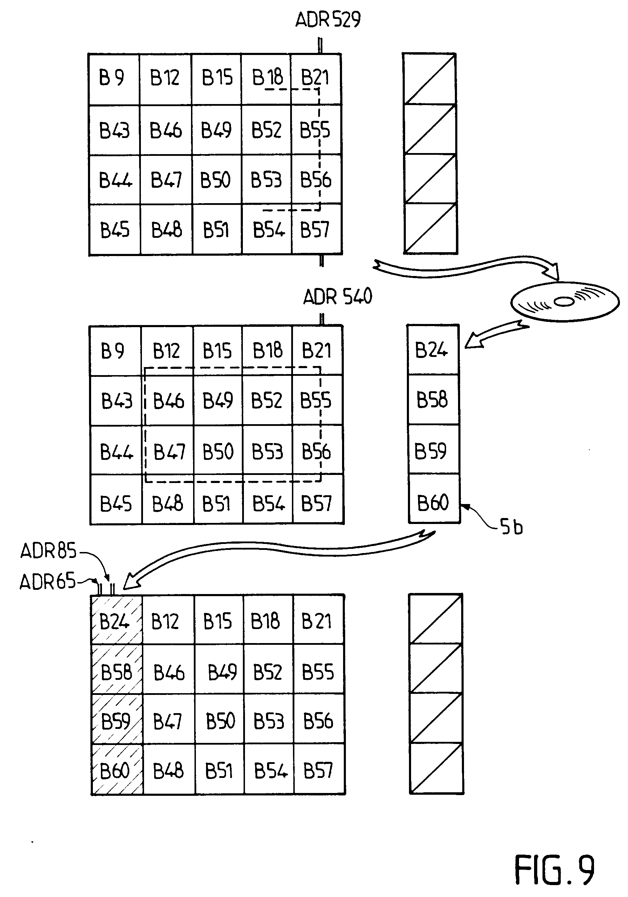

Lorsque le bord droit de RE touche le bord du rectangle de lecture RR, ce qui est facilement détectable en traitant les codes de début de lignes par comparaison avec les adresses de début des codes des rectangles de lecture (si le code d'adresse de la première ligne NL1 est telle que N1L + 384 ≥ 529 - cf. figure 9), il y a une demande d'accès de lecture au lecteur de CD, les informations sont alors emmagasinées dans la partie 5b de la mémoire ; les blocs B24, B58, B59 et B60 sont enregistrés dans la partie de la mémoire 5b.

Si aucun déplacement supplémentaire n'est demandé aucune action n'est entreprise. Par contre, si on persiste à demander un déplacement vers la droite, le rectangle écran va toucher le rectangle de transfert par exemple (N1L + 384 ≥ 549), les données contenues dans la partie 5b vont alors venir remplacer les données anciennes c'est-à-dire que les blocs B24, B58, B59 et B60 vont remplacer les blocs B9, B43, B44 et B45. Le transfert des données peut se faire physiquement ou par voie logicielle en décalant les adresses.

On notera que le temps d'accès plutôt long aux informations contenues dans le CD est surmonté par ce chargement préalable dans la partie 5b.

Il convient de remarquer que le transfert s'effectue dans des parties de la mémoire 5a disjointe de la partie concernée par le rectangle d'écran et n'affecte pas la visualisation de la carte sur l'écran.

Ce transfert s'accompagne évidemment d'une mise à jour de la définition des rectangles de lecture RR, d'écran RE et de transfert RT en ce qui concerne l'adressage de la mémoire 5a.

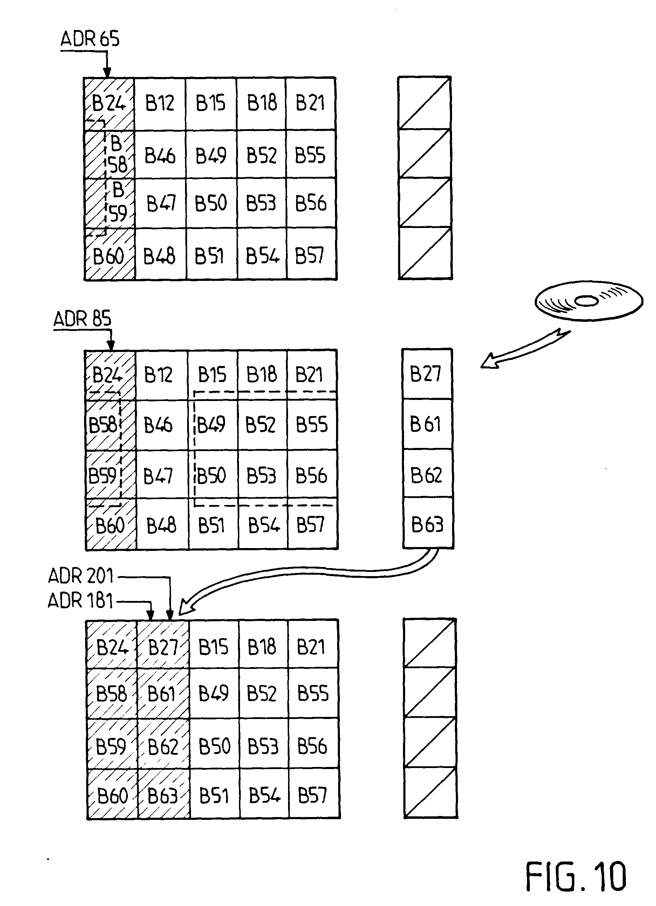

A la figure 10 on a représenté l'évolution des informations lorsqu'on persiste dans le déplacement à droite. Ainsi les blocs B27, B61, B62 et B63 remplacent les blocs B12, B46, B47 et B48.

On notera que les bords droits des rectangles de lecture et de transfert passent de ADR65 + k.580, ADR85 + k.580 à ADR181 + k.580, ADR201 + k.580 où k représente le numéro de ligne où l'on considère ce bord.

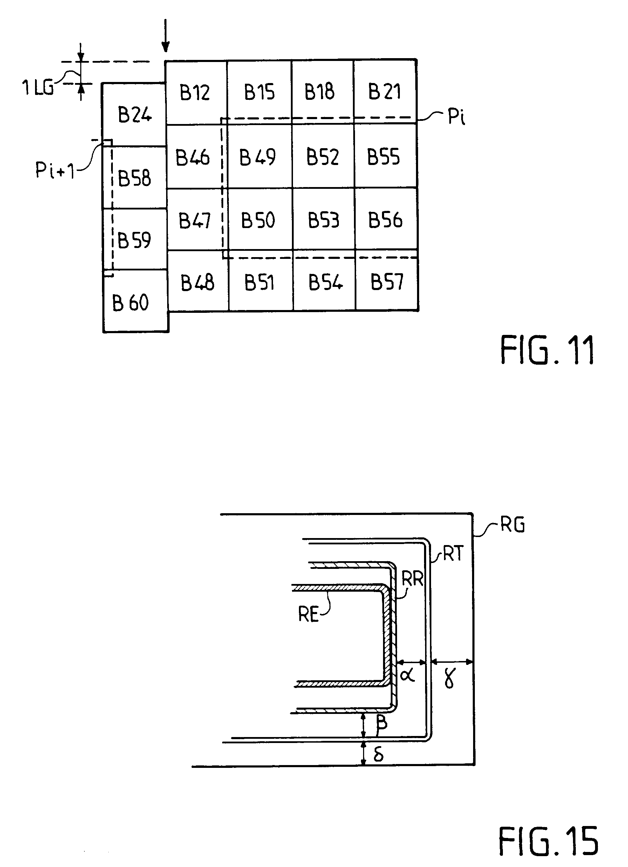

La figure 11 explicite un peu plus le transfert des blocs de la partie 5b dans la partie 5a. Pour montrer qu'il faut prévoir un décalage d'une ligne on a décalé sur cette figure 11, les blocs B24, B58, B59 et B60 vers le bas d'une manière exagérée afin de bien montrer ce décalage vers le bas. Ce décalage est justifié par le fait que le pixel Pi situé en bordure du rectangle global RG doit être situé à côté du pixel Pi + 1 en raison du rangement unidimensionnel des mémoires informatiques. Si le pixel Pi est situé à l'adresse ADR579 + k.580, le pixel Pi + 1 doit être situé à l'adresse ADR580 + k.580 ou à l'adresse ADR0 + (k+1)580, donc à une ligne en dessous.

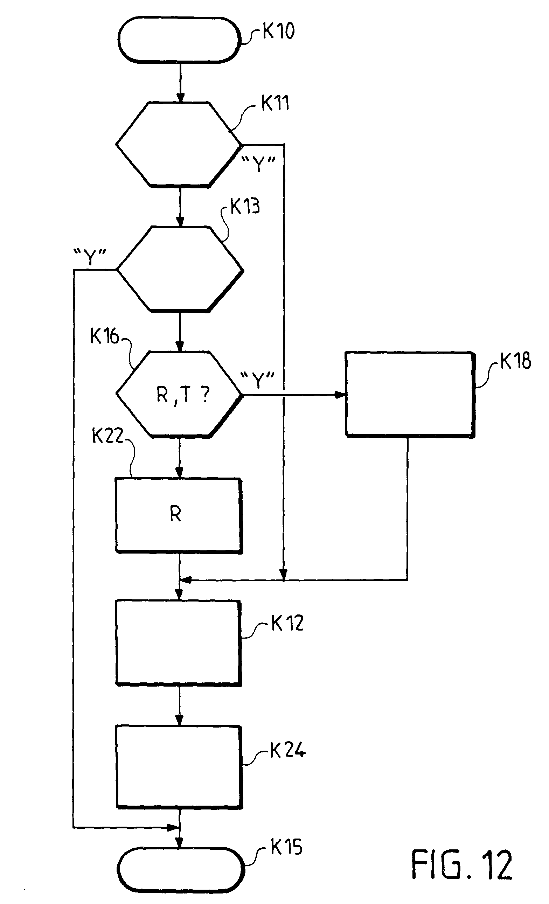

La figure 12 montre un premier organigramme expliquant le fonctionnement du dispositif de l'invention.

Le processus explicité par cet organigramme est déclenché lorsqu'une demande de déplacement est demandée (case K10).

Le processus démarre alors par un test indiqué à la case K11 pour savoir si tous les éléments de l'image à visualiser sont contenus dans la mémoire 5a. Pour cela, on compare les valeurs d'adresse des débuts de lignes augmentées de l'incrément imposé par le déplacement demandé aux valeurs préétablies. Si les éléments sont contenus on passe à la case K12.

Si les éléments ne sont pas contenus on teste si on est au bord de la carte (case K13). Il y a là impossibilité de charger des données supplémentaires depuis le disque compact. Si c'est impossible, aucune action n'est entreprise et on revient au système, case K15.

Si un chargement est possible on passe à la case K16 où l'on teste si une demande de lecture ou de transfert est en cours, si oui on mémorise la demande de déplacement K18 et l'on passe à la case K12. Si il n'y a pas de lecture ou de transfert on passe à la case K22 où une demande de lecture est demandée.

Puis on prépare le décalage à visualiser en mettant à jour les codes de début de ligne (case K12) puis on autorise le décalage (case K24) puis on retourne au système.

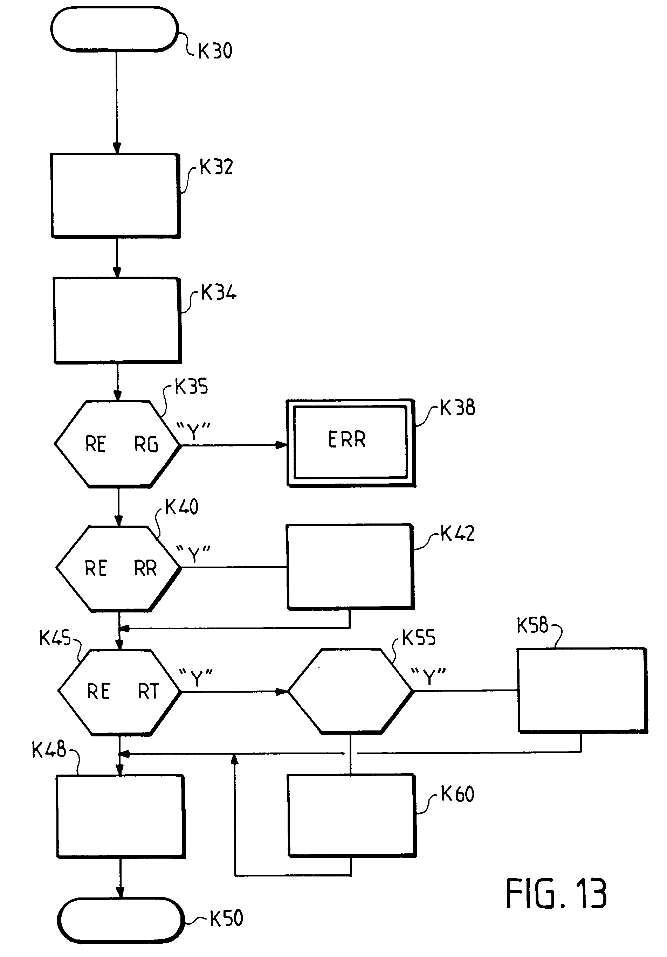

Le processus explicité par l'organigramme montré à la figure 13 est déclenché par un processus de décalage case K30 puis, à la case K32 on rafraîchit l'écran c'est-à-dire que l'on rend active la table de début de ligne mise à jour, ce qui implique que le rectangle écran se déplace dans le rectangle global case K34.

Si le rectangle écran rencontre un bord du rectangle global (test de la case K35) on déclenche un programme d'erreur case K38.

Si il n'y a pas d'erreur on teste si le rectangle écran rencontre le rectangle de lecture case K40. Si oui on va à la case K42 où un accès au disque compact est lancé, si non on va à la case K45.

A la case K45 on examine si le rectangle écran rencontre le rectangle de transfert, si non on va à la case K48 où l'on met à jour la mémoire des codes de début de ligne et l'on met à jour aussi le contenu des rectangles de transfert et de lecture et l'on passe à la case K50 où l'on retroune au système.

Si le test de la case K45 est positif on va à la case K55 où l'on teste si une opération de lecture déjà demandée est finie ou non. Si l'opération de lecture n'est pas finie on va à la case K58 où l'on bloque tout transfert des données de la mémoire supplémentaire dans la mémoire contenant le rectangle global puis on va à la case K48.

Si la demande de lecture est finie, on passe de la case K55 à la case K60 où le transfert est effectué.

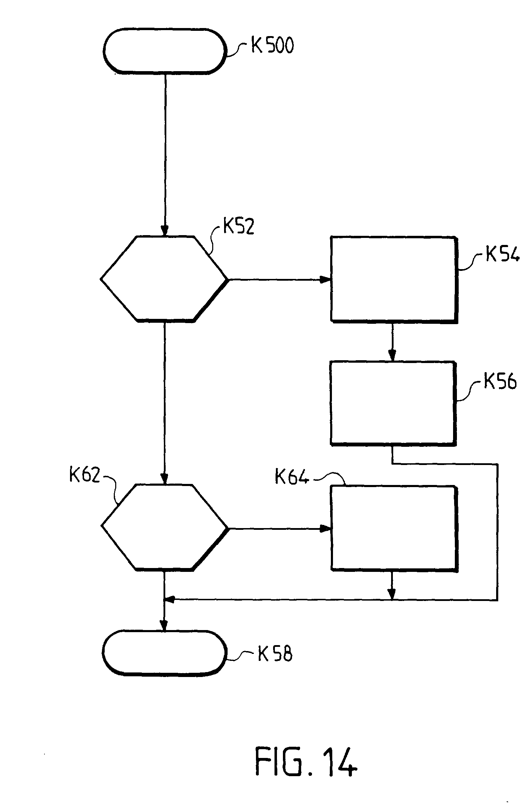

Le processus indiqué par l'organigramme de la figure 14 est déclenché par la fin de la lecture du disque compact case K500.

On teste ensuite case K52 si une demande de déplacement a été demandée par exemple à la case K18. Si oui on va à la case K54 où l'on relance une lecture du CD puis le processus de décalage K56 avant de revenir au système case K58. Si aucun décalage n'a été demandé on passe de la case K52 à la case K62 où l'on teste si une demande de transfert n'a pas été bloquée (par exemple voir case K58). Si oui on effectue le transfert case K64 et on retourne au système case K58. Si aucun transfert n'a été demandé, on passe de la case K62 à la case K58.

Pour obtenir un déplacement satisfaisant il y a lieu de faire un choix judicieux des différents paramètres. Ce choix est basé sur les considérations suivantes :

1 - Le nombre de pixels contenu dans un bloc doit être le plus proche possible d'un multiple k du nombre d'octets $V_{CD}$ contenu dans un secteur vidéo du CD (soit 2324 octets). Si w est la largeur, en pixel, d'un bloc et h sa hauteur, on doit avoir la relation :

$$w.h \# k.V_{CD}$$

2 - Le temps de lecture d'une rangée de blocs d'un rectangle écran doit être à peu près égal au temps de lecture d'une colonne de blocs. Si W est le nombre de blocs dans une rangée, H le nombre de blocs dans une colonne, $t_R$ le temps de lecture d'un bloc et $t_{seek}$ le temps de positionnement de la tête de lecture au CD, on doit avoir la relation :

$$W.t_R + t_{seek} \# H.t_R + 2.t_{seek}$$

3 - Pour avoir une mémoire tampon de taille minimale il faut que r soit minimum :

$$\frac{(W.w) \times (H.h)}{W_{SC} \times h_{SC}} = r$$

où

$W_{SC} = $ largeur en pixel du rectangle écran,
$h_{SC} = $ hauteur en pixel du rectangle écran.

4 - Sachant que le déplacement s'effectue sur le temps de retour trame $T_{RT}$ du balayage de l'écran, il faut que :

$$\alpha.T_{RT} > T_{RLCD}$$

que :

$$\beta.T_{RT} > T_{RRCD}$$

que :

$$\gamma.T_{RT} > T_{RM} + T_{OR}$$

et que :

$$\delta.T_{RT} > T_{RM} + T_{OR}$$

où

$\alpha$ représente le nombre de pixels disposés horizontalement, séparant RR de RT,
$\beta$ représente le nombre de pixels disposés verticalement, séparant RR de RT,
$\gamma$ représente le nombre de pixels disposés horizontalement, séparant RT de RG,
$\delta$ représente le nombre de pixels disposés verticalement, séparant RT de RG,

(on se reportera à la figure 15 où les grandeurs sont mieux illustrées).

$T_{RLCD}$ est le temps de lecture pris par le CD pour lire une rangée,
$T_{RRCD}$ est le temps de lecture pris par le CD pour lire une colonne,
$T_{RM}$ est le temps de transfert des blocs contenus dans la mémoire supplémentaire vers la mémoire 5a,

$T_{OR}$ est le temps pour mettre à jour les différents rectangles RR, RT et RG dans la mémoire tampon.

5 - Si $H_S$ et $W_S$ est le nombre (pas forcément entier) de blocs correspondant au rectangle RE on doit avoir :

$$W-2 < W_S < W-1$$

$$H-2 < H_S < H-1$$

ainsi il n'y a qu'une colonne ou une rangée à charger dans la mémoire supplémentaire.

Il est évident que ces considérations peuvent amener à d'autres valeurs que celles données ci-dessus, sans pour cela sortir du cadre de l'invention comme défini dans les revendicaitons.

**Revendications**

1. Dispositif pour visualiser sur un écran des vues partielles d'une image, dispositif comportant :

   - une mémoire de masse pour emmagasiner tous les pixels de l'image préalablement numérisée,
   - un organe de visualisation muni d'un écran pour visualiser les vues partielles,
   - une mémoire tampon pour recevoir des informations de la mémoire de masse et pour alimenter l'organe de visualisation,
   - un circuit d'utilisateur pour sélectionner des vues partielles se déduisant les unes des autres par scrolling en agissant sur une commande de déplacement,

   caractérisé en ce que la mémoire tampon est divisée en au moins :

   - une première partie dite partie globale comprenant :

     . une sous-partie de transfert contenant
     . une sous-partie de lecture contenant
     . une sous-partie d'écran correspondant à la partie visualisée, la sous-partie d'écran se déplaçant en fonction du mouvement de la commande de déplacement,

   - une deuxième partie dite partie supplémentaire destinée à recevoir les informations de la mémoire de masse lorsque la sous-partie d'écran entre en contact avec la sous-partie de lecture, et à fournir à la partie globale ces informations lorsque la sous-partie d'écran entre en contact avec la sous-partie de transfert.

2. Dispositif pour visualiser sur un écran des vues partielles d'une image, selon la revendication 1, caractérisé en ce que l'image est décomposée en blocs disposés en lignes et en colonnes et en ce que la partie supplémentaire est prévue pour emmagasiner une ligne ou une colonne selon le déplacement requis afin de remplacer dans la partie globale la ligne ou la colonne qui n'est plus concernée par les vues partielles à visualiser.

3. Dispositif pour visualiser sur un écran des vues partielles d'une image, selon la revendication 1 ou 2, caractérisé en ce qu'il est prévu des moyens de contact prédéterminé pour estimer le contact entre la sous-partie d'écran et la sous-partie de lecture d'une part, et la sous-partie d'écran et la sous-partie de transfert d'autre part.

4. Dispositif pour visualiser sur un écran des vues partielles d'une image, selon l'une des revendications 1 à 3, caractérisé en ce que les sous-parties d'écran, les sous-parties de lecture et les sous-parties de transfert correspondent pratiquement à des surfaces rectangulaires.

5. Dispositif pour visualiser sur un écran des vues partielles d'une image, selon l'une des revendications 1 à 4, utilisant un circuit à "c" canaux vidéo, caractérisé en ce que, pour enregistrer l'image dans la mémoire de masse l'image est analysée selon "k" groupes de "c" rangées de "n" blocs (k étant un entier suffisamment grand pour l'analyse totale de l'image), chaque rangée est affectée à un canal de sorte que les blocs sont enregistrés pour chaque groupe, un par un, canal par canal et ceci groupe par groupe.

6. Procédé pour visualiser une partie mobile d'une image enregistrée sous forme de blocs de pixels au moyen d'un dispositif de traitement d'images, ce dispositif comprenant :

   - une mémoire de masse dans laquelle tous lesdits blocs de l'image sont enregistrés,
   - un circuit utilisateur muni de moyens de défilement pour déplacer la partie mobile sur l'image,
   - une mémoire tampon pour stocker des blocs provenant de la mémoire de masse pour contenir au moins un groupe de pixels visualisés correspondant à ladite partie mobile, procédé caractérisé en ce qu'il comprend les étapes suivantes :

     a) on divise la mémoire tampon en :

       . une partie globale ayant :
       un premier ensemble de limites d'adressage définissant un premier groupe de "m" rangées par "n" colonnes de blocs qui est organisé hiérarchiquement en une section de transfert ayant un deuxième ensemble de limites d'adressage à l'intérieur dudit premier ensemble, cette section de transfert comprenant une section de lecture ayant un troisième ensemble de limites d'adressage compris dans le deuxième ensemble de limites d'adressage, cette section de lecture comprenant une section d'écran ayant un ensemble variable de limites d'adressage définissant ledit groupe de pixels visualisés défini par au plus "m-1" rangées par "n-1" colonnes,

. une partie supplémentaire ayant la capacité pour stocker le plus grand nombre de blocs qu'une rangée ou une colonne contient,

b) on utilise lesdits moyens de défilement pour choisir ledit ensemble variable pour définir ledit groupe de pixels visualisés parmi ceux contenus dans ladite partie globale,

c) on enregistre un deuxième groupe de blocs provenant de la mémoire de masse vers la partie supplémentaire quand au moins une desdites limites dudit ensemble variable rencontre au moins une desdites limites du troisième ensemble,

d) on transfère le deuxième groupe de blocs depuis ladite partie supplémentaire vers la partie globale quand au moins une desdites limites dudit ensemble variable rencontre au moins une desdites limites section du deuxième ensemble de limites d'adressage,

e) on met à jour tous les ensembles de limites d'adressage après le transfert pour prendre en compte les blocs transférés.

7. Procédé selon la revendication 6, caractérisé en ce que lors de l'étape c) le deuxième groupe comprend "m" blocs de rangée quand le mouvement de la partie mobile est dirigé vers une rangée ou "n" blocs quand la partie mobile est dirigée vers une colonne.

**Patentansprüche**

1. Anordnung zur Darstellung von Teilansichten eines Bildes auf einem Bildschirm, wobei die Anordnung folgendes umfaßt:

- einen Massenspeicher zur Speicherung aller Pixel des zuvor digitalisierten Bildes,

- eine Darstellungsvorrichtung, die mit einem Bildschirm zur Darstellung der Teilansichten ausgestattet ist,

- einen Pufferspeicher zum Empfang der Informationen des Massenspeichers und zur Versorgung der Darstellungsvorrichtung,

- eine Bedienungsschaltung zur Selektierung der sich voneinander ableitenden Teilansichten durch Scrolling, indem ein Verschiebe-Bedienelement betätigt wird,

dadurch gekennzeichnet, daß der Pufferspeicher wenigstens aufgeteilt ist in:

- einen ersten Teil, genannt globaler Teil, der folgendes umfaßt:

. einen untergeordneten Transferteil mit darin

. einem untergeordneten Leseteil mit darin

. einem untergeordneten Bildschirmteil, der dem dargestellten Teil entspricht, wobei sich der Bildschirmteil in Abhängigkeit der Bewegung des Verschiebe-Bedienelementes verschiebt,

- einen zweiten Teil, genannt zusätzlicher Teil, der dazu bestimmt ist, die Informationen aus dem Massenspeicher zu empfangen, wenn der untergeordnete Bildschirmteil in Kontakt mit dem untergeordneten Leseteil kommt, und dem globalen Teil seine Informationen zu liefern, wenn der untergeordnete Bildschirmteil in Kontakt mit dem untergeordneten Transferteil kommt.

2. Anordnung zur Darstellung von Teilansichten eines Bildes auf einem Bildschirm nach Anspruch 1, dadurch gekennzeichnet, daß das Bild in Blöcke zerlegt ist, die in Zeilen und Spalten angeordnet sind und daß der zusätzliche Teil dazu vorgesehen ist, eine Zeile oder eine Spalte entsprechend der gewünschten Verschiebung zu speichern, um im globalen Teil die Zeile oder Spalte zu ersetzen, die von den wiederzugebenden Teilansichten nicht mehr betroffen ist.

3. Anordnung zur Darstellung von Teilansichten eines Bildes auf einem Bildschirm nach Anspruch 1 oder 2, dadurch gekennzeichnet, daß Mittel für vorbestimmten Kontakt vorgesehen sind, um den Kontakt zwischen dem untergeordneten Bildschirmteil und dem untergeordneten Leseteil einerseits und zwischen dem untergeordneten Bildschirmteil und dem untergeordneten Transferteil andererseits zu beurteilen.

4. Anordnung zur Darstellung von Teilansichten eines Bildes auf einem Bildschirm nach einem der Ansprüche 1 bis 3, dadurch gekennzeichnet, daß der untergeordnete Bildschirmteil, der untergeordnete Leseteil und der untergeordnete Transferteil praktisch rechteckigen Flächen entsprechen.

5. Anordnung zur Darstellung von Teilansichten eines Bildes auf einem Bildschirm nach einem der Ansprüche 1 bis 4, die eine Schaltung mit "c" Videokanälen benutzt, dadurch gekennzeichnet, daß zur Speicherung des Bildes im Massenspeicher das Bild entsprechend "k" Gruppen mit "c" Reihen mit "n" Blöcken analysiert wird (wobei k für die Gesamtanalyse des Bildes eine genügend große ganze Zahl ist), daß jede Reihe einem Kanal zugeordnet ist, so daß die Blöcke für jede Gruppe einer nach dem anderen per Kanal gespeichert werden, und dies Gruppe für Gruppe.

6. Verfahren zur Darstellung eines beweglichen Teils eines in Form von Pixelblöcken gespeicherten Bildes mittels einer Bildverarbeitungsanordnung, wobei diese Anordnung folgendes umfaßt:

- einen Massenspeicher, in dem alle genannten Blöcke des Bildes gespeichert werden,
- eine Bedienungsschaltung, die mit Scrolling-Mitteln zur Verschiebung des beweglichen Teil des Bildes versehen ist,
- einen Pufferspeicher zur Speicherung der aus dem Massenspeicher kommenden Blöcke und zur Aufnahme von wenigstens einer Gruppe von dargestellten Pixeln, die dem genannten beweglichen Teil entspricht,

dadurch gekennzeichnet, daß es die folgenden Schritte umfaßt:

a) der Pufferspeicher wird unterteilt in:

. einen globalen Teil mit:
einer ersten Einheit von eine erste Gruppe von "m" Reihen mal "n" Spalten von Blöcken definierenden Adressierungsgrenzen, die hierarchisch in einen Transferbereich mit einer zweiten Einheit von Adressierungsgrenzen innerhalb der genannten ersten Einheit organisiert ist, wobei dieser Transferbereich einen Lesebereich mit einer dritten Einheit von Adressierungsgrenzen umfaßt, der in der zweiten Einheit von Adressierungsgrenzen enthalten ist, wobei dieser Lesebereich einen Bildschirmbereich mit veränderlichen Adressierungsgrenzen umfaßt, die die genannte Gruppe von dargestellten Pixeln definieren, die durch höchstens "m-1" Reihen mal "n-1" Spalten definiert werden,

. einen zusätzlichen Teil, der die Kapazität zur Aufnahme der größten Anzahl von Blöcken hat, die eine Reihe oder Spalte enthalten kann,

b) die genannten Scrolling-Mittel werden verwendet, um die genannte veränderliche Einheit zu wählen, um die genannte Gruppe von dargestellten Pixeln unter den im genannten globalen Teil enthaltenen Pixeln auszuwählen,
c) eine zweite Gruppe von aus dem Massenspeicher kommenden Blöcken wird in dem zusätzlichen Teil gespeichert, wenn wenigstens eine der genannten Grenzen der genannten veränderlichen Einheit auf wenigstens eine der genannten Grenzen der dritten Einheit trifft,
d) die zweite Gruppe von Blöcken wird von dem genannten zusätzlichen Teil in den globalen Teil transferiert, wenn wenigstens eine der genannten Grenzen der genannten veränderlichen Einheit auf wenigstens eine der genannten Bereichsgrenzen der zweiten Einheit von Adressierungsgrenzen trifft,
e) alle Einheiten von Adressierungsgrenzen werden nach dem Transfer aktualisiert, damit die transferierten Blöcke berücksichtigt werden.

7. Verfahren nach Anspruch 6, dadurch gekennzeichnet, daß während des Schrittes c) die zweite Gruppe "m" Reihenblöcke umfaßt, wenn die Bewegung des beweglichen Teils in Richtung einer Reihe verläuft, oder "n" Blöcke umfaßt, wenn der bewegliche Teil in Richtung einer Spalte verläuft.

**Claims**

1. A device for displaying partial views of an image on a screen, said device comprising:

- a bulk memory for storing all pixels of the image digitized in advance,
- a display member having a screen for displaying the partial views,
- a buffer memory for receiving information from the bulk memory and for feeding the digital member,
- a user circuit for selecting partial views obtained by scrolling in response to a movement control,

characterized in that the buffer memory is divided into at least:

- a first section which is referred to as the global section and which comprises:

  - a transfer subsection, containing
  - a reading subsection, containing

- a screen subsection, corresponding to the part displayed, said screen subsection being moved in accordance with the movement control;

- a second section which is referred to as the supplementary section and which is intended to receive the information from the bulk memory when the screen subsection comes into contact with the reading subsection, and to apply this information to the global section when the screen subsection comes into contact with the transfer subsection.

2. A device for displaying partial views of an image on a screen, as claimed in Claim 1, characterized in that the image is divided into blocks arranged in rows and columns, the supplementary section being suitable for storing a row or a column of blocks in dependence on the movement required to replace in the global section the row or column of blocks which no longer concerns partial views to be displayed.

3. A device for displaying partial views of an image on a screen, as claimed in Claim 1 or 2, characterized in that there are provided given contact means for estimating the contact between the screen subsection and the reading subsection on the one side and the screen subsection and the transfer subsection on the other side.

4. A device for displaying partial views of an image on a screen, as claimed in any one of the Claims 1 to 3, characterized in that the screen subsections, the reading subsections and the transfer subsections correspond substantially to rectangular surfaces.

5. A device for displaying partial view of an image on a screen, as claimed in any one of the Claims 1 to 4, utilizing a circuit with "c" video channels, characterized in that for the storage of the image in the bulk memory the image is analyzed according to "k" groups of "c" rows of "n" blocks (k being an integer which is large enough for complete analysis of the image) each row is assigned to a channel in such a manner that the blocks are stored for each group, one by one, channel by channel, and group by group.

6. A method of displaying a mobile part of an image stored in the form of blocks of pixels by means of an image processing device, which device comprises:

- a bulk memory in which all of said blocks of the image are stored,
- a user circuit provided with advancing means for moving the mobile part in the image,
- a buffer memory for storing the blocks from the bulk memory in order to store at least one group of pixels displayed, corresponding to said mobile part, which method is characterized in that it comprises the following steps:

a) dividing the buffer memory into:

• a global section with:
a first set of addressing limits which define a first group of "m" rows and "n" columns of blocks which is hierarchically organized as a transfer section having a second set of addressing limits within said first set, said transfer section comprising a reading section having a third set of addressing limits contained within the second set of addressing limits, said reading section comprising a screen section having a variable set of addressing limits defining said group of displayed pixels which is defined by at the most "m-1" rows and "n-1" columns,
• a supplementary section having enough capacity to store the largest number of blocks contained in a row or column,

b) using said advancing means for selecting said variable set in order to define said group of displayed pixels from among those contained in said global section,
c) storing a second group of blocks from the bulk memory to the supplementary section if at least one of said limits of said variable set encounters at least one of said limits of the third set,
d) transferring the second group of blocks from said supplementary section to the global section if at least one of said limits of said variable set encounters at least one of said section limits of the second set of addressing limits,
e) updating all sets of addressing limits after the transfer in order to take into account the blocks transferred.

7. A method as claimed in Claim 6, characterized in that during the step c) the second group comprises "m" blocks of rows when the movement of the mobile part is directed towards a row or "n" blocks if the mobile part is directed towards a column.

FIG. 1

EP 0 516 233 B1

FIG.2

11

EP 0 516 233 B1

| B1 | B4 | B7 | B10 | B13 | B16 | B19 | B22 | B25 | B28 | B31 | B34 | } CH1 |
|----|----|----|-----|-----|-----|-----|-----|-----|-----|-----|------|-------|
| B2 | B5 | B8 | B11 | B14 | B17 | B20 | B23 | B26 | B29 | B32 | B35 | } CH2 |
| B3 | B6 | B9 | B12 | B15 | B18 | B21 | B24 | B27 | B30 | B33 | B36 | } CH3 |
| B37 | B40 | -- | -- | -- | -- | -- | -- | -- | -- | -- | B70 | } CH1 |
| B38 | -- | -- | -- | -- | -- | | | -- | -- | -- | B71 | } CH2 |
| B39 | -- | -- | | | | | | | | -- | B72 | } CH3 |
| B73 | | | | | | | | | | | B106 | } CH1 |
| B74 | | | | | | | | | | | B107 | } CH2 |
| B75 | -- | -- | -- | -- | -- | -- | -- | -- | -- | -- | B108 | } CH3 |

FIG.3

FIG. 4

FIG. 5

FIG.6

EP 0 516 233 B1

FIG. 7

ADR 0

ADR 579

ADR 580

ADR 277820

ADR 278399

RG

RR

RE

RT

EP 0 516 233 B1

15

FIG. 8

ADR 529

| B 9 | B 12 | B 15 | B 18 | B 21 |
|-----|------|------|------|------|
| B 43 | B 46 | B 49 | B 52 | B 55 |
| B 44 | B 47 | B 50 | B 53 | B 56 |
| B 45 | B 48 | B 51 | B 54 | B 57 |

ADR 540

| B 9 | B 12 | B 15 | B 18 | B 21 |
|-----|------|------|------|------|
| B 43 | B 46 | B 49 | B 52 | B 55 |
| B 44 | B 47 | B 50 | B 53 | B 56 |
| B 45 | B 48 | B 51 | B 54 | B 57 |

| B 24 |
|------|
| B 58 |
| B 59 |
| B 60 |

5 b

ADR 85
ADR 65

| B 24 | B 12 | B 15 | B 18 | B 21 |
|------|------|------|------|------|
| B 58 | B 46 | B 49 | B 52 | B 55 |
| B 59 | B 47 | B 50 | B 53 | B 56 |
| B 60 | B 48 | B 51 | B 54 | B 57 |

# FIG. 9

ADR 65

| B24 | B12 | B15 | B18 | B21 |
| B58 | B46 | B49 | B52 | B55 |
| B59 | B47 | B50 | B53 | B56 |
| B60 | B48 | B51 | B54 | B57 |

ADR 85

| B24 | B12 | B15 | B18 | B21 |
| B58 | B46 | B49 | B52 | B55 |
| B59 | B47 | B50 | B53 | B56 |
| B60 | B48 | B51 | B54 | B57 |

| B27 |
| B61 |
| B62 |
| B63 |

ADR 201
ADR 181

| B24 | B27 | B15 | B18 | B21 |
| B58 | B61 | B49 | B52 | B55 |
| B59 | B62 | B50 | B53 | B56 |
| B60 | B63 | B51 | B54 | B57 |

FIG. 10

FIG. 11

FIG. 15

FIG. 12

K30

K32

K34

K35

RE    RG    "Y"    →    ERR    K38

K40

RE    RR    "Y"    K42

K45

RE    RT    "Y"    →    K55    "Y"    K58

K48                    K60

K50

FIG. 13

FIG. 14